(19) Europäisches Patentamt
European Patent Office
Office européen des brevets

(11) EP 1 635 393 A1

(12) EUROPEAN PATENT APPLICATION
published in accordance with Art. 158(3) EPC

(43) Date of publication:
15.03.2006 Bulletin 2006/11

(51) Int Cl.:
$H01L\ 27/092$ (1990.01)   $H03H\ 19/00$ (1980.01)
$H01L\ 29/78$ (1974.07)   $H01L\ 21/336$ (1990.01)

(21) Application number: 04745814.6

(22) Date of filing: 11.06.2004

(86) International application number:
PCT/JP2004/008220

(87) International publication number:
WO 2004/112143 (23.12.2004 Gazette 2004/52)

(84) Designated Contracting States:
DE

(30) Priority: 13.06.2003 JP 2003170103

(71) Applicants:
• KABUSHIKI KAISHA TOYOTA JIDOSHOKKI
Kariya-shi,
Aichi-ken 448-8671 (JP)
• Niigata Seimitsu Co., Ltd.
Niigata 943-0834 (JP)
• OHMI, Tadahiro
Sendai-shi,
Miyagi 980-0813 (JP)

(72) Inventors:
• OHMI, Tadahiro;
Sendai-shi, Miyagi 9800813 (JP)
• NISHIMUTA, Takefumi,
K.K. Toyota Jidoshikki
Kariya-shi, Aichi 4488671 (JP)
• MIYAGI, Hiroshi,
Nigata Semitsu Co., Ltd.
Joetsu-shi, Niigata 9430834 (JP)
• SUGAWA, Shigetoshi
Sendai-shi, Miyagi 9800861 (JP)
• TERAMOTO, Akinobu
Sendai-shi, Miyagi 9830037 (JP)

(74) Representative: TBK-Patent
Bavariaring 4-6
80336 München (DE)

(54) SWITCH CAPACITOR CIRCUIT AND SEMICONDUCTOR INTEGRATED CIRCUIT THEREOF

(57)    A rectangular parallelepiped projecting portion (21) having a height of $H_B$ and a width of $W_B$ is formed on a silicon substrate, and a gate oxide film is formed on a part of the top surface and the side surface of the projecting portion (21), thereby generating a MOS transistor. By connecting in parallel a p-channel MOS transistor and an n-channel MOS transistor produced as described above, a switch of a switched capacitor circuit is configured, thereby reducing a leak current and a DC offset of the switched capacitor circuit.

F I G . 4

EP 1 635 393 A1

## Description

### Technical Field

The present invention relates to a switched capacitor circuit formed on the substrate of a semiconductor integrated circuit, and a semiconductor integrated circuit including the switched capacitor circuit.

### Background Art

Conventionally, in the production process of a MOS transistor, a thermal oxide film is formed on the silicon surface at a high temperature of 800°C as a gate insulating film.

It is requested to form an oxide film at a lower temperature environment to enhance the production efficiency of a semiconductor. To realize this request, for example, the patent document 1 discloses the technology of forming an insulating film in a low temperature plasma atmosphere.

When a filter is formed on the substrate of an integrated circuit, a switched capacitor filter is used.

When a p-channel MOS transistor and an n-channel MOS transistor are connected in parallel and used as a switch of a switched capacitor circuit, a problem occurs; noise is generated during switching because the parasitic capacity of the p-channel MOS transistor is different from the parasitic capacity of the n-channel MOS transistor.

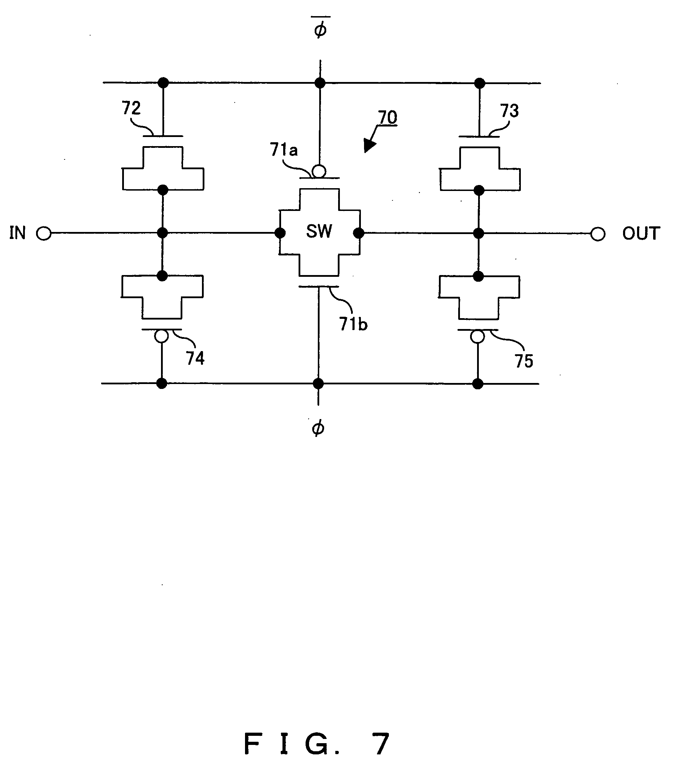

To solve the problem, the circuit as shown in Fig. 7 has been conventionally used.

In Fig. 7, switch 70 is configured by connecting p-channel MOS transistor 71a and n-channel MOS transistor 71b in parallel.

In parallel with the gate and the source of the p-channel MOS transistor 71a, the gate of the n-channel MOS transistor 72 is connected to the capacity between the terminals connecting the source and the drain, and in parallel with the gate and the drain of the p-channel MOS transistor 71a, the gate of an n-channel MOS transistor 73 is connected to the capacity between the terminals connecting the source and the drain.

In parallel with the gate and the drain of the n-channel MOS transistor 71b, the gate of a p-channel MOS transistor 74 is connected to the capacity between the terminals commonly connecting the source and drain, and in parallel with the gate and the drain of the n-channel MOS transistor, the gate of a p-channel MOS transistor 75 is connected to the capacity of the terminals connecting the source and the drain.

With the above-mentioned configuration, the capacity between the gate and the source and the gate and drain of the p-channel MOS transistor 71a and the capacity between the gate and the source and the gate and the drain of the n-channel MOS transistor 71b are substantially equal.

When a switched capacitor filter is formed on the substrate of the integrated circuit, there is the problem that a filter characteristic based on the designed value cannot be obtained due to the leak current of a transistor and the offset voltage of an operational amplifier.

To solve the problem, the example in patent document 2 describes a switched capacitor provided for offset compensation to remove the influence of the DC offset of an operational amplifier.

The patent document 3 describes forming a three-dimensional gate on a silicon substrate.

Patent Document 1: Japanese Published Patent Application No. 2002-261091

Patent Document 2: Japanese Published Patent Application No. 2000-22500 (Fig. 1)

Patent Document 3: Japanese Published Patent Application No. 2002-110963 (Fig. 1)

As described above, it is requested to reduce the error of the integration value of the switched capacitor circuit generated by a leak current of a MOS transistor, a DC offset, etc.

Since the circuit shown in Fig. 7 requires the transistors 72 through 75 to be added to the switch 70, the scale of the circuit is increased.

Furthermore, when a CMOS switch is used, there has been the problem that the fluctuation width of an output voltage is large when the switch is turned to the on and off positions because the parasitic capacity of the p-channel MOS transistor is larger than the parasitic capacity of the n-channel MOS transistor.

### Disclosure of the Invention

The present invention aims at reducing the error of a switched capacitor circuit, and also aims at reducing the noise and the voltage fluctuation during switching.

The switched capacitor circuit according to the present invention is formed on a substrate of a semiconductor integrated circuit, and includes: a MIS (metal insulator semiconductor) field-effect transistor in which a projecting portion is formed by a silicon substrate having a first crystal surface as a primary surface and a second crystal surface as a side surface, terminated hydrogen on the silicon surface is removed in plasma atmosphere of an inert gas, then a gate insulating film is formed on at least a part of the top surface and the side surface of the projecting portion at a temperature at or lower than about 550°C in the plasma atmosphere, a gate is formed on the gate insulating film, and a drain and a source are formed on both sides enclosing the gate insulating film of the projecting portion; and a capacitor./

An inert gas is formed by, for example, argon, krypton, xenon, etc.

According to the present invention, a leak current and a DC offset of a MIS field-effect transistor can be reduced. Therefore, the error of the switched capacitor circuit can be decreased and a circuit, for compensating for the DC offset is not required.

Furthermore, since the capacity between the gate and the drain and the capacity between the gate and the source of the p-channel MOS transistor and the n-channel MOS transistor can be substantially equal to each other, a circuit for reducing the switching noise is not required.

In addition, the current drive capability of a MIS field-effect transistor can be improved and the device area of the MIS field-effect transistor on the primary surface of a silicon substrate can be smaller.

In the above-mentioned invention, a channel is formed on the first crystal surface of the top surface and the second crystal surface of the side surface of the projecting portion, and the channel width of the MIS field-effect transistor is at least a total of the channel width of the top surface and the channel width of the side surface.

With the above-mentioned configuration, since a channel is formed on different crystal surfaces, the characteristic of the MIS field-effect transistor can be improved.

In the above-mentioned invention, the projecting portion has a top silicon surface (100) and the side silicon surface (110), with the source and the drain formed in the left and right areas of the projecting portion and the projecting portion of the silicon substrate enclosing the gate.

With the above-mentioned configuration, a channel can be formed on the surfaces (100) and (110) of the silicon substrate. Therefore, the current drive capability of the field-effect transistor can be improved.

In the above-mentioned invention, the switched capacitor circuit includes a switch having a p-channel MIS field-effect transistor and an n-channel MIS field-effect transistor connected in parallel, and the gate width of the top surface and the side surface of the p-channel MIS field-effect transistor is set such that the current drive capability of the p-channel MIS field-effect transistor can be substantially equal to the current drive capability of the n-channel MIS field-effect transistor.

With the above-mentioned configuration, since the capacity between the gate and the source and the capacity between the gate and the drain of the p-channel MIS field-effect transistor and the n-channel MIS field-effect transistor forming the switch can be substantially equal to each other, the noise during switching can be reduced. Furthermore, since the parasitic capacity of the p-channel MIS field-effect transistor can be smaller, the fluctuation of the output voltage of the switch can be reduced.

In the above-mentioned invention, the switched capacitor circuit includes: first p-channel and n-channel MIS field-effect transistors, which receive a signal at an input terminal, and are connected in parallel to each other; second p-channel and n-channel MIS transistors, which are connected to each other and whose input terminals are connected to output terminals of the first p-channel and n-channel MIS field-effect transistor, and output terminals are grounded; a capacitor, one terminal of which is connected to an output terminal of the first p-channel and n-channel MIS field-effect transistors; third p-channel and n-channel MIS field-effect transistors, which are connected in parallel to each other, whose input terminal is connected to another terminal of the capacitor, and output terminal is grounded; and fourth p-channel and n-channel MIS field-effect transistors, which are connected in parallel to each other and whose input terminal is connected to another terminal of the capacitor.

With the above-mentioned configuration, the capacity between the gate and the source and the capacity between the gate and the drain of the p-channel MIS field-effect transistor and the n-channel MIS field-effect transistor forming the switch of the switched capacitor circuit can be substantially equal to each other, thereby reducing the noise during switching.

The semiconductor integrated circuit according to the present invention includes: a circuit including a p-channel MIS field-effect transistor and an n-channel MIS field-effect transistor in which a projecting portion is formed by a silicon substrate having a first crystal surface as a primary surface and a second crystal surface as a side surface, terminated hydrogen on the silicon surface is removed in the plasma atmosphere of an inert gas, then a gate insulating film is formed on at least a part of the top surface and the side surface of the projecting portion at a temperature at or lower than about 550°C in the plasma atmosphere, a gate is formed on the gate insulating film, and a drain and a source are formed on both sides enclosing the gate insulating film of the projecting portion; and a switched capacitor circuit having the p-channel MIS field-effect transistor or the n-channel MIS field-effect transistor and a capacitor.

According to the invention, the leak current and the DC offset of the MIS field-effect transistor can be reduced. Therefore, the error of the switched capacitor circuit can be decreased and a circuit, for compensating for the DC offset is not required.

Additionally, the capacity between the gate and the drain and the capacity between the gate and the source of the p-channel MOS transistor and the n-channel MOS transistor can be substantially equal to each other, thereby requiring no circuit for reducing the switching noise.

Furthermore, since the characteristics of the p-channel MIS field-effect transistor and the n-channel MIS field-effect transistor of other circuits can be prepared, for example, the DC offset and 1/f noise of the differential amplification circuit connected at the subsequent stage can be reduced.

In addition, by forming a gate insulating film on a different crystal surface in the three-dimensional structure, the current drive capability of the MIS field-effect transistor can be improved and the device area of the MIS field-effect transistor on the primary surface of the silicon substrate can be made smaller.

In the above-mentioned invention, the gate widths of the top surface and the side surface of the p-channel MIS field-effect transistor and the n-channel MIS field-effect transistor are set such that the current drive capability of the p-channel MIS field-effect transistor can be substantially equal to the current drive capability of the n-channel MIS field-effect transistor.

With the above-mentioned configuration, the capacity between the gate and the source and the capacity between the gate and the drain of the p-channel MIS field-effect transistor and the n-channel MIS field-effect transistor can be substantially equal to each other, thereby reducing the noise during switching.

**Brief Description of the Drawings**

Fig. 1 is a sectional view of the plasma device using a radial line slot antenna;
Fig. 2 shows the comparison of the interface level density;
Fig. 3 shows the structure of a silicon substrate generated in the semiconductor production process according to the embodiment of the present invention;
Fig. 4 shows the structure of the MOS transistor in the semiconductor producing process according to the embodiment of the present invention;
Fig. 5 shows a receiving circuit of the direct conversion system;
Fig. 6 shows a switched capacitor circuit; and
Fig. 7 shows the configuration of the conventional switch.

**Best Mode for Carrying Out the Invention**

An embodiment of the present invention is explained below by referring to the attached drawings. Described below is a semiconductor production process of forming a gate insulating film (for example, an oxide film) on the silicon substrate at a low temperature using an inert gas in a plasma state, and producing a MIS (metal insulator semiconductor) field-effect transistor. The method for forming a gate insulating film is disclosed in Japanese Published Patent Application No. 2002-261091.

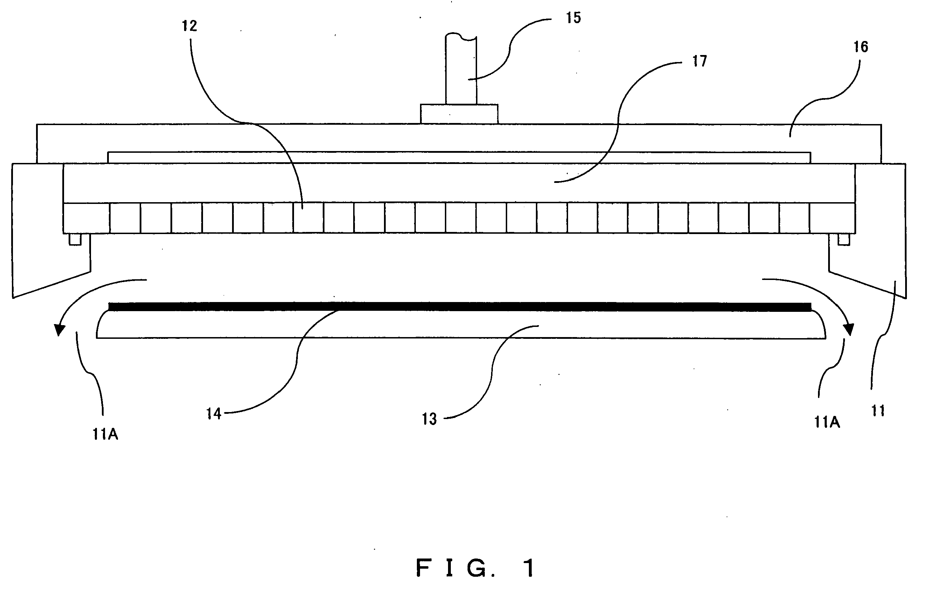

Fig. 1 is a sectional view of the plasma device using a radial line slot antenna to be used in the semiconductor producing process.

A vacuum is produced in a vacuum container (processing chamber) 11, argon gas (Ar) is introduced from a shower plate 12, the Ar gas is exhausted from an outlet 11A, and the gas is switched to a krypton gas. The pressure in the processing chamber 11 is set to 133 Pa (1 Torr).

Then, a silicon substrate 14 is placed on a sample table 13 having a heating mechanism, and the temperature of a sample is set to approximately 400°C. If the temperature of the silicon substrate 14 is between 200°C and 550°C, the following result is almost the same.

The silicon substrate 14 is cleansed with noble fluoride acid in the pretreatment process performed immediately before, and the unused coupling of silicon on the surface is terminated with hydrogen as a result.

Next, a microwave at the frequency of 2.45 GHz is supplied from a coaxial waveguide 15 to a radial line slot antenna 16, and the microwave is introduced from the radial line slot antenna 16 to the processing chamber 11 through a dielectric plate 17 provided in a portion of the wall. The introduced microwave pumps the Kr gas introduced from the shower plate 12 to the processing chamber 11. As a result, high density Kr plasma is formed immediately below the shower plate 12. If the frequency of the provided microwave is about 900 MHz or more and about 10 GHz or less, the following results are almost the same.

With the configuration shown in Fig. 1, the interval between the shower plate 12 and the silicon substrate 14 is set to about 6 cm. The film can be formed at a higher speed with the smaller interval.

The plasma can be pumped by introducing the microwave to the processing chamber using another method without limiting the plasma device to a device using a radial line slot antenna.

By exposing the silicon substrate 14 to the plasma pumped by the Kr gas, the surface of the silicon substrate 14 receives the irradiation of Kr ion of low energy, and the surface terminated hydrogen is removed.

Then, $Kr/O_2$ mixed gas having the partial pressure ratio of 97/3 is introduced from the shower plate 12. At this time, the pressure in the processing chamber is to be kept at approximately 133 Pa (1 Torr). In the high density pumped plasma as a mixture of Kr gas and $O_2$ gas, the Kr* and the $O_2$ molecule in the intermediate pumped state conflict with each other, and a large amount of atomic oxygen O* can be efficiently generated.

In the present embodiment, the surface of the silicon substrate 14 is oxidized by the atomic oxygen O*. In the conventional thermal oxidation method, oxidation is performed by an $O_2$ molecule and an $H_2O$ molecule, and a very high process temperature over 800 °C is required. In the oxidization process using the atomic oxygen performed in the present embodiment, the oxidization process can be performed at a very low temperature, approximately 400°C. To extend the conflict opportunity between Kr* and $O_2$, it is preferable that a higher pressure is kept in the processing chamber. However, if the pressure is too high, the generated O* conflict with each other and is returned to an $O_2$ molecule. Therefore, the optimum gas pressure is to be maintained.

When the desired thickness of film of a silicon oxide film (silicon compound layer) is formed, the introduction of the microwave power is stopped to terminate the plasma pumping, and the Kr/$O_2$ mixture gas is replaced with Ar gas, thereby terminating the oxidization process. The Ar gas is used before and after the present process to use as a purging gas that is less expensive than Kr. The Kr gas used in this process is collected for recycling.

After forming the above-mentioned oxide film, an electrode forming process, a protective film forming process, a hydrogen sintering process, etc. are performed to generate a semiconductor integrated circuit including a transistor and a capacitor.

After measuring the hydrogen content in the silicon oxide film formed in the above-mentioned procedure, it is lower than $10^{12}$ /$cm^2$ in the surface density conversion on the silicon oxide film of the film thickness of 3nm. On the oxide film that has an especially small leak current, the hydrogen content in the silicon oxide film is $10^{11}$/$cm^2$ or less in the surface density conversion. Otherwise, the oxide film not exposed to the Kr plasma before forming the oxide film contains hydrogen at $10^{12}$/$cm^2$ or more in the surface density conversion.

When the oxidization process is performed with the Kr/$O_2$ gas introduced after removing the terminated hydrogen by irradiation with Kr plasma as described above, the leak current at the same voltage as the silicon oxide film formed by the conventional microwave plasma oxidization is reduced by two or three digits of the leak current; thereby obtaining an excellent low leak feature. The improvement of the leak current feature has been confirmed in the production of an integrated circuit using the silicon oxide film having the film thickness up to about 1.7 nm.

When the surface direction dependency of the silicon/silicon oxide film interface level density is measured relating to the silicon oxide film obtained in the above-mentioned semiconductor producing process, a very low interface level density of about $1 \times 10^{10}$ $eV^{-1}$ $cm^{-2}$ is obtained any of the surface direction of the silicon surface.

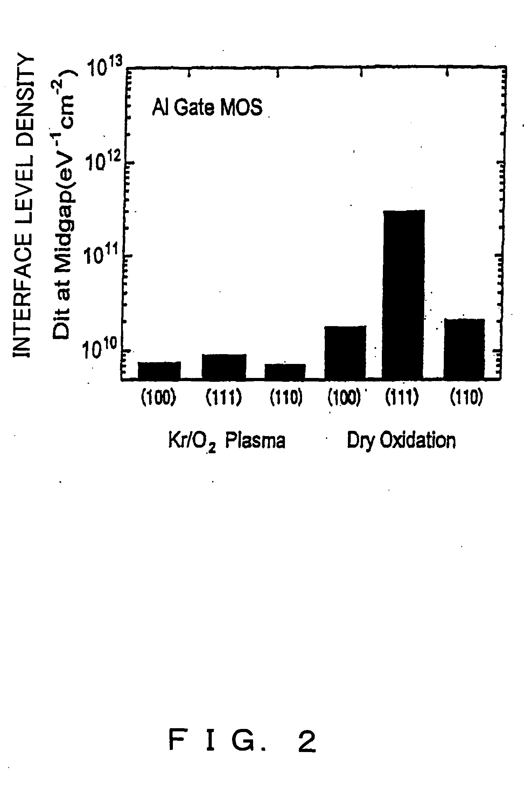

Fig. 2 shows the Kr/$O_2$ film formed by the above-mentioned semiconductor producing process on each of the surfaces (100), (110), and (111) of a silicon substrate, and a result of measuring the interface level density of the conventional thermal oxide film.

As shown in Fig. 2, when the Kr/$O_2$ film is generated, the interface level density of the semiconductor on any of the surfaces (100), (110), and (111) is $10^{10}$ $eV^{-1}$ $cm^{-2}$ or lower. On the other hand, the interface level density of the thermal oxide film formed in the atmosphere higher than the conventional 800°C is 1.1 times or more on the surface (100), and in the above-mentioned semiconductor production process, a high quality insulating film of a low interface level density can be formed.

By lowering the interface level density, the probability of recombining a carrier can be reduced, thereby lowering the 1/f noise.

Relating to the electric features such as the pressure-resistant feature, the hot carrier resistance, the electric charge QBD (charge-to-breakdown) up to the destruction of the silicon oxide film when a stress current flows, etc. and the reliability feature, the oxide film formed in the semiconductor production process indicates good features equivalent to or higher than the conventional thermal oxide film.

As described above, high grade silicon oxidization process on all surface directions at a low temperature of 400°C can be achieved by performing the silicon oxidization process using Kr/$O_2$ high-density plasma after removing the surface terminated hydrogen. It is considered that the above-mentioned effect can be obtained by decreasing the hydrogen content in the oxide film by removing the terminated hydrogen, and by containing an inert gas (Kr, for example) in the oxide film. By a small amount of hydrogen in the oxide film, there is no weak coupling of elements in the silicon oxide film, and by containing Kr, the stress in the film or on the Si/$SiO_2$ interface is moderated. As a result, the electric characteristic of the silicon oxide film can be largely improved.

In the above-mentioned semiconductor production process, it is assumed that a hydrogen density of $10^{12}$/$cm^2$ or less in the surface density conversion, or $10^{11}$/$cm^2$ or less as a desired condition, and Kr density of $5 \times 10^{11}$ /$cm^2$ or less contribute to the improvement of the electric characteristics and reliability characteristics of the silicon oxide film.

In the above-mentioned semiconductor process, a silicon nitride film and a silicon oxide and nitride film can be formed using a mixture of an inert gas and a $NH_3$ gas and a mixture of an inert gas, $O_2$, and $NH_3$.

The effect obtained by forming a nitride film is mainly based on the presence of hydrogen in plasma even after removing the surface terminated hydrogen. With the hydrogen in plasma, the dangling bond in the silicon nitride film and on the interface forms a coupling of Si-H and N-H and is terminated, and, as a result, the electronic trap in the silicon nitride film and on the interface disappear.

It is considered that the effect obtained by forming an oxide and nitride film is caused not only by the decrease in the hydrogen content in the oxide and nitride film by removing the terminated hydrogen, but also by some percents of nitrogen contained in the oxide and nitride film. The Kr content in the oxide and nitride film is 1/10 or less of the content in the oxide film, and the content of nitrogen is larger than that of Kr. That is, since the hydrogen content is small in the oxide and nitride film, the rate of weak couplings in the silicon nitride film decreases, and the contained nitrogen moderates the stress in the film, $Si/SiO_2$, or on the interface. As a result, it is considered that the charge in the film and the interface level density decrease, and the electric characteristic of the oxide and nitride film is largely improved.

The desired result obtained by forming an oxide film or an oxide and nitride film is not only caused by removing the terminated hydrogen, but also caused by containing Ar or Kr in the nitride film or the oxide and nitride film. That is, in the nitride film obtained in the above-mentioned semiconductor production process, the Ar or Kr contained in the nitride film moderates the stress on the silicon/nitride film interface As a result, the fixed charge in the silicon nitride film and the interface level density are reduced, and the electric characteristic, especially the 1/f noise is reduced, thereby largely improving the reliability.

The inert gas used in the above-mentioned semiconductor production process is not limited to Ar gas, or Kr gas, but xenon Xe gas can also be used.

Furthermore, after forming a silicon oxide film and a silicon nitride film, the pressure in a vacuum container 11 is maintained at 133 Pa (1 Torr), a gas mixture of Kr/NH 3 at a partial pressure ratio of 98/2 is introduced, and about a 0.7 nm silicon nitride film can be formed on the surfaces of a silicon oxide film and a silicon oxide and nitride film.

Thus, a silicon oxide film having a silicon nitride film formed on the surface, or a silicon oxide and nitride film can be obtained. Therefore, an insulating film having a high dielectric constant can be formed.

To realize the above-mentioned semiconductor production process, in addition to the device shown in Fig. 1, another plasma process device capable of forming a low temperature oxide film using plasma can be used. For example, it is possible to use a 2-stage shower plate type plasma process device having the first gas emission structure of emitting an Ar or Kr gas for pumping plasma, and a second gas emission structure, which is different from the first gas emission structure and emits an $O_2$, $NH_3$, or $N_2/H_2$ gas.

Described below is the semiconductor production process according to the embodiment of the present invention. The semiconductor process forms a gate insulating film of a MIS field-effect transistor on the surface (100) and the surface (110).

When a p-channel transistor is formed on the surface (111), 1.3 times the current drive capability of the surface (100) is obtained. If it is formed on the surface (100), 1.8 times the current drive capability of the surface (100) is obtained.

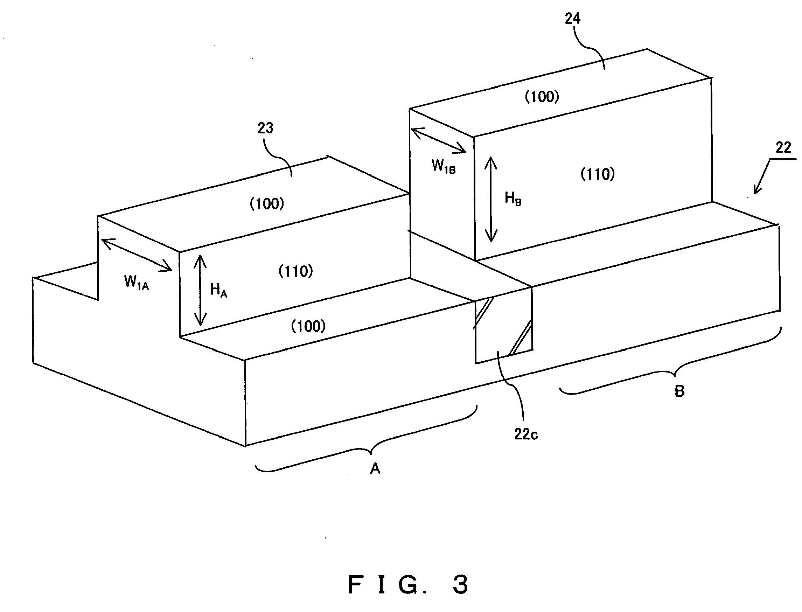

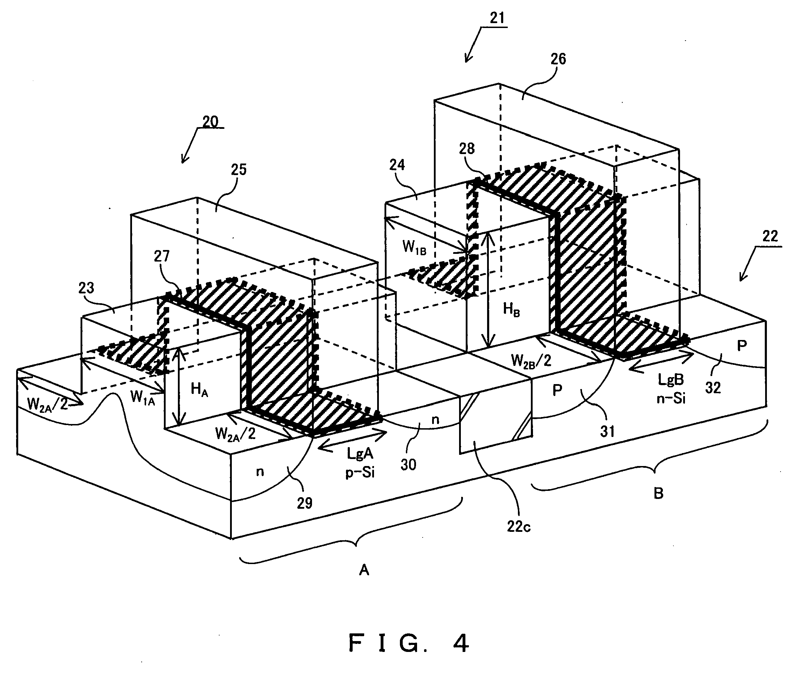

Fig. 3 shows the state of forming projecting portions 23 and 24 having surfaces (100) and (110) on a silicon substrate 22 in the semiconductor producing process according to the embodiment of the present invention. Fig. 4 shows the structures of n-channel MOS transistor 20 and p-channel MOS transistor 21 produced in the semiconductor producing process according to the embodiment of the present invention. Fig. 4 shows a channel formed at the lower portion of the gate oxide film and indicated by diagonal lines.

As shown in Fig. 3, the silicon substrate 22 having the surface (100) as a primary surface is separated by a device separation area 22c into p-type area A and an n-type area B. In area A, the rectangular parallelepiped projecting portion 23 having a height of $H_A$ and a width of $W_{1A}$ is formed on the reference of the surface (100). Similarly, in area B, the projecting portion 24 having a height of $H_B$ and a width of $W_{1B}$ is formed.

As shown in Fig. 4, a silicon oxide film is formed in the semiconductor production process on the surface of the silicon substrate 22 and the top surfaces and the side surfaces of the projecting portions 23 and 24.

On the silicon oxide film, polysilicon gate electrodes 25 and 26 are formed, the silicon oxide film is patterned when the polysilicon gate electrodes 25 and 26 are formed, and gate insulating films 27 and 28 are formed below the polysilicon gate electrodes 25 and 26.

In addition, an n-type impure ion is injected into the areas on both sides of the gate electrode 25 of the p-type area A, thereby forming n-type diffusion areas 29 and 30 including the projecting portion 23. The n-type diffusion areas 29 and 30 configure the source and the drain of the n-channel MOS transistor 20. Also in the n-type area B, a p-type impure ion is injected into the areas on both sides of the gate electrode 26, thereby forming p-type diffusion areas 31 and 32 including the projecting portion 24. The p-type diffusion areas 31 and 32 configure the source and drain of the p-channel MOS transistor 21.

When a predetermined voltage is applied to the gate electrodes 25 and 26 of the p-channel MOS transistor 21 and the n-channel MOS transistor 20, a channel indicated by the diagonal lines shown in Fig. 4 is formed below the gate oxide films 27 and 28.

The gate width of the surface (100) of the n-channel MOS transistor 20 is $W_{1A}$ on the top surface of the projecting portion 23, and $W_{2A}/2$ on the flat portions of the silicon substrate 22 on the right and left below the projecting portion 23. Therefore, the gate width is now a total of $W_{1A} + W_{2A}$. Similarly, the gate width of the surface (110) of the n-channel MOS transistor 20, that is, the gate widths of the left and right side surfaces of the projecting portion 23 are $H_A$. Therefore, it is now a total of $2H_A$. The gate width corresponds to the channel width. The gate length of the n-channel MOS transistor 20 is LgA.

Accordingly, the current drive capability of the n-channel MOS transistor 20 is expressed by $\mu_{n1}$ ($W_{1A}$ + $W_{2A}$) + $\mu_{n2}$· $2H_A$. $\mu_{n1}$ indicates the electron mobility on the surface (100) and $\mu_{n2}$ indicates the electron mobility on the surface (110).

Similarly, the gate width of the surface (100) of the p-channel MOS transistor 21 is $W_{1B}$ on the top surface of the projecting portion 24, and $W_{2B}/2$ at the flat portions of the silicon substrate 22 on the left and right below the projecting portion 24 respectively. Therefore, the gate width is a total of $W_{1B}$ + $W_{2B}$. The gate width of the surface (110) of the p-channel MOS transistor 21, that is, the gate widths on the left and right side surfaces of the projecting portion 24 are $H_B$. As a result, the gate width is a total of $2H_B$. The gate width corresponds to the channel width. The gate length of the p-channel MOS transistor 21 is LgB.

Therefore, the current drive capability of the p-channel MOS transistor 21 can be expressed by $\mu_{p1}$ ($W_{1B}$ + $W_{2B}$) + $\mu_{p2}$· $2H_B$. $\mu_{p1}$ indicates the Hall mobility on the surface (100), and $\mu_{p2}$ indicates the Hall mobility on the surface (110).

Thus, by adjusting the respective heights $H_A$ and $H_B$ of the projecting portions 23 and 24, the current drive capability of the p-channel MOS transistor 21 and the current drive capability of the n-channel MOS transistor 20 can be balanced. This condition can be expressed by the following equation.

$$\mu_{n1}\ (W_{1A}\ +\ W_{2A})\ +\ \mu_{n2}·\,2H_A\ =\ \mu_{p1}\ (W_{1B}\ +\ W_{2B})\ +\ \mu_{p2}·\,2\ H_B$$

By setting the $H_A$ and $H_B$ to the values satisfying the equation above, the current drive capability of the p-channel MOS transistor 21 and the current drive capability of the n-channel MOS transistor 20 can be balanced. In this case, it is not necessary that the channel width of the primary surface (for example, the surface (100)) of the p-channel MOS transistor 21 is exceedingly larger than the channel width on the surface (100) of the n-channel MOS transistor 20. Therefore, the difference in parasitic capacity by a gate insulating film can be smaller between them. Thus, when a circuit of a CMOS structure is configured using the p-channel MOS transistor 21 and the n-channel MOS transistor 20, the current value imbalance caused when the parasitic capacity by the gate oxide film is charged or discharged can be reduced, and the noise level caused when the transistor of the CMOS structure is switched can be lowered.

The height $H_B$ of the p-channel MOS transistor 21 can be set such that, after setting the height $H_A$ of the gate of the n-channel MOS transistor 20 to "0", the current drive capability of the p-channel MOS transistor 21 can be substantially equal to the current drive capability of the n-channel MOS transistor 20.

Since the area of the gate on the primary surface (for example, the surface (100)) of the silicon substrate of the p-channel or the n-channel MOS transistor can be smaller than in the conventional semiconductor production process when the p-channel MOS transistor 21 or the n-channel MOS transistor 20 is individually formed, the area on the primary surface on the silicon substrate of the p-channel MOS transistor and the n-channel MOS transistor can be smaller, thereby enhancing the integration of the semiconductor circuit. Furthermore, since the parasitic capacities of the p-channel and N-channel MOS transistors can be made smaller, the switching speed of the MOS transistors can be increased, and the power consumption at the switching can be reduced.

The insulating film formed on the silicon surface is not limited to an oxide film, but a silicon nitride film, or a silicon oxide and nitride film, etc. can be formed.

Described below is the case where a switched capacitor filter is formed on the semiconductor integrated circuit in the above-mentioned semiconductor production process.

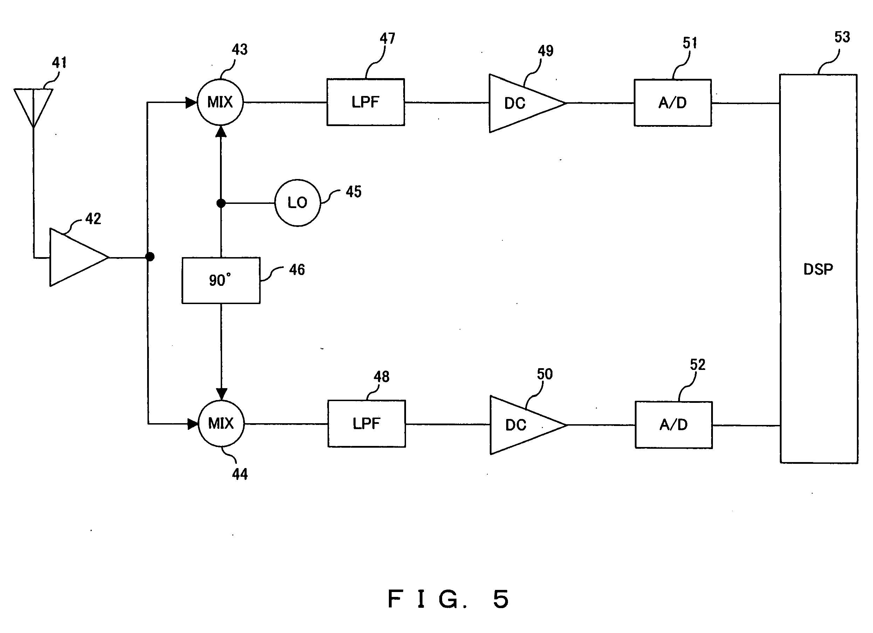

Fig. 5 shows the important portion of the circuit of the direct conversion receiver formed on the substrate of a semiconductor circuit.

A radio signal received by the antenna 41 is amplified by the low noise amplifier 42, and input to the mixer circuits 43 and 44.

A local signal generated by the local oscillation circuit 45 is input to the other input terminal of the mixer circuit 43, and the local signal is 90 degrees phase-shifted by the phase shifter 46 and the obtained local signal is input to the other input terminal of the mixer circuit 44.

In the mixer circuits 43 and 44, the received signals and their local signals are mixed, and are converted to baseband signals having a 90 degree phase shift. Then, the low pass filters 47 and 48 formed by a switched capacitor filter, etc. attenuate a signal over a predetermined frequency, and output a resultant signal to the DC amplifiers 49 and 50.

The DC amplifiers 49 and 50 amplify the baseband signal to the signal level depending on the resolution of the A/D converters 51 and 52.

The A/D converters 51 and 52 convert an analog baseband signal to a digital signal, and outputs the signal to the digital signal processor (DSP) 53. The DSP 53 performs digital signal processing and demodulates the signal.

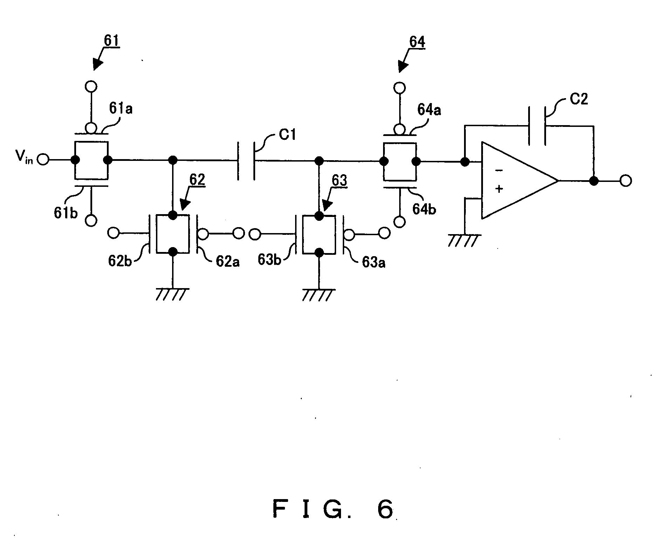

An example of a switched capacitor circuit using a CMOS switch is explained below by referring to Fig. 6.

In Fig. 6, a switch 61 is configured by connecting a p-channel MOS transistor 61a and an n-channel MOS transistor 61b in parallel. An input signal Vin is sent to the input terminal of the switch 61, and an output terminal is connected to a capacitor C1.

A switch 62 is configured by connecting a p-channel MOS transistor 62a and an n-channel MOS transistor 62b in parallel. The input terminal of the switch 62 is connected to the output terminal (one terminal of the capacitor C1) of the switch 61, and the output terminal is grounded.

A switch 63 is configured by connecting a p-channel MOS transistor 63a and an n-channel MOS transistor 63b in parallel. The input terminal of the switch 63 is connected to the other terminal of the capacitor C1, and the output terminal is grounded.

A switch 64 is configured by connecting a p-channel MOS transistor 64a and an n-channel MOS transistor 64b in parallel. The input terminal of the switch 64 is connected to the other terminal (input terminal of the switch 63) of the capacitor C1, and the output terminal is connected to the inverted input terminal of the operational amplifier and the capacitor C2.

The capacitor C2 is connected between the inverted input terminal of an operational amplifier 65 and the output terminal, and a non-inverted input terminal is grounded.

The operation of the circuit is explained below.

A signal for simultaneously turning the switches 61 and 63 to the ON positions is input to the gates of the p-channel MOS transistor 61a and the n-channel MOS transistor 61b (switch 61) and the p-channel MOS transistor 63a and the n-channel MOS transistor 63b (switch 63).

A signal for simultaneously turning the switches 61 and 63 to the ON positions when the switch 61 and switch 63 are in the OFF positions is input to the gates of the p-channel MOS transistor 62a and the n-channel MOS transistor 62b (switch 62) and the p-channel MOS transistor 64a and the n-channel MOS transistor 64b (switch 64).

When a signal is inputted to the gate, and the switches 61 and 63 are turned ON, the capacitor C1 is charged by the input voltage Vin, the switches 61 and 63 are turned off, and when the switches 62 and 64 are turned ON, the charge of the capacitor C1 is transferred to the other capacitor C2.

When a switched capacitor circuit is produced in the above-mentioned semiconductor process, and the capacity between the gate and the source and the capacity between the gate and the drain of the p-channel MOS transistor and the n-channel MOS transistor are made to be equal to each other, the noise is thereby reduced during switching. Thus, a circuit for compensating for the difference in parasitic capacity between the p-channel MOS transistor and the n-channel MOS transistor is not required. Additionally, the device area of the p-channel MOS transistor configuring the switch can be reduced to make the parasitic capacity smaller, thereby decreasing the change width of the output voltage of the switch.

Eliminating the damage of the silicon surface and leveling the surface can reduce the variance of the characteristics (for example, threshold voltage, etc.) of the MOS transistors, thereby reducing the leak current and the DC offset, and decreasing the error of the integration value of the switched capacitor circuit. Furthermore, a capacitor can be configured using the above-mentioned oxide film to improve the characteristics of the capacitor.

By forming a three-dimensional structure and a gate oxide film on a different crystal surface, the current drive capability of a MOS transistor can be improved, and the device area of a transistor on the primary surface of the silicon substrate can be smaller.

The switch of the switched capacitor circuit is not limited to the structure of a parallel-connected p-channel MOS transistor and an n-channel MOS transistor as in the embodiments, but can also be configured by an n-channel MOS transistor only or a p-channel MOS transistor only. In these cases, the variance of the characteristic of a MOS transistor can be reduced and the effect of decreasing the leak current and DC offset can be obtained as well. Again, the device area of a MOS transistor can be smaller.

Additionally, a p-channel MOS transistor and an n-channel MOS transistor such as a circuit other than the switched capacitor circuit, for example, a DC amplifier, an A/D conversion circuit, a digital circuit, etc. can be produced in the above-mentioned semiconductor process.

With the above-mentioned configuration, the characteristics of the n-channel MOS transistors and the n-channel MOS transistors of other circuits can be prepared. Therefore, the DC offset and 1/f noise can be reduced. Furthermore, since the current drive capability of a MOS transistor can be improved, the operation characteristic of a circuit can also be improved.

Furthermore, the channels of the p-channel MOS transistors and the n-channel MOS transistors of other circuits can be formed on different crystal surfaces of silicon (for example, surfaces (100) and (110)), and the channel widths can be designed to be equal in current drive capability between the p-channel MOS transistor and the n-channel MOS transistor.

With the above-mentioned configuration, the p-channel MOS transistor can be equal in parasitic capacity, etc. to the n-channel MOS transistor, and the parasitic capacity can be smaller, thereby increasing the operation speed of the MOS transistor and reducing the noise generated by a current when the MOS transistor is turned on and off.

The present invention can be configured as follows without being limited to the above-mentioned embodiment.

The application of the present invention is not limited to the switched capacitor circuit, but the present invention can also be applied to a switched capacitor filter, etc.

The crystal surface of silicon is not limited to the combination of the surfaces (100) and (110), but can be other combinations such as a combination of surfaces (100) and (111), etc.

According to the present invention, the leak current and the DC offset of the MIS field-effect transistor of the switched capacitor circuit can be reduced. Therefore, a circuit for compensating for them is not required. In addition, by setting the current drive capability of the p-channel MIS field-effect transistor configuring switch to be substantially equal to the current drive capability of the n-channel MIS field-effect transistor, the noise and the voltage change of an output voltage can be reduced during switching. Furthermore, the DC offset and the noise during switching of other circuits connected to the switched capacitor circuit can also be reduced.

**Claims**

1. A switched capacitor circuit formed on a substrate of a semiconductor integrated circuit, comprising:

   an MIS field-effect transistor in which a projecting portion is formed by a silicon substrate having a first crystal surface as a primary surface and a second crystal surface as a side surface, terminated hydrogen on the silicon surface is removed in a plasma atmosphere of an inert gas, then a gate insulating film is formed on at least a part of the top surface and the side surface of the projecting portion at a temperature at or lower than about 550°C in the plasma atmosphere, a gate is formed on the gate insulating film, and a drain and a source are formed on both sides enclosing the gate insulating film of the projecting portion; and a capacitor.

2. The circuit according to claim 1, wherein
   a channel is formed on a first crystal surface of a top surface and a second crystal surface of a side surface of the projecting portion, and the channel width of the MIS field-effect transistor is a total of a channel width of the top surface and a channel width of the side surface.

3. The computer according to claim 1 or 2, wherein
   the projecting portion has a top surface comprising a silicon surface (100), the side surface comprising a silicon surface (110), and the source and drain are formed on the projecting portion enclosing the gate and in left and right areas of the projecting portion of the silicon substrate.

4. The circuit according to claim 1 or 2, wherein
   the switched capacitor circuit comprises a switch formed by connecting in parallel a p-channel MIS field-effect transistor and n-channel MIS field-effect transistor, and a gate width of a top surface and the side surface of the projecting portion of the p-channel MIS field-effect transistor is set such that current drive capability of the p-channel MIS transistor can be substantially equal to current drive capability of the n-channel MIS transistor.

5. The circuit according to claim 1 or 2, wherein
   the switched capacitor circuit comprises: first p-channel and n-channel MIS field-effect transistors which receive a signal at an input terminal, and are connected in parallel to each other; second p-channel and n-channel MIS transistors which are connected to each other, whose input terminals are connected to output terminals of the first p-channel and n-channel MIS field-effect transistor, and whose output terminals are grounded; a capacitor one terminal of which is connected to an output terminal of the first p-channel and n-channel MIS field-effect transistors; third p-channel and n-channel MIS field-effect transistors which are connected in parallel to each other, whose input terminal is connected to another terminal of the capacitor, and whose output terminal is grounded; and fourth p-channel and n-channel MIS field-effect transistors which are connected in parallel to each other and whose input terminal is connected to another terminal of the capacitor.

6. A semiconductor integrated circuit, comprising:

   a circuit comprising a p-channel MIS field-effect transistor and an n-channel MIS field-effect transistor in which a projecting portion is formed by a silicon substrate having a first crystal surface as a primary surface and a second crystal surface as a side surface, terminated hydrogen on the silicon surface is removed in plasma atmosphere of an inert gas, then a gate insulating film is formed on at least a part of the top surface and the side surface of the projecting portion at a temperature at or lower than about 550°C in the plasma atmosphere, a gate is formed on the gate insulating film, and a drain and a source are formed on both sides enclosing the gate insulating film of the projecting portion; and a switched capacitor circuit comprising the p-channel MIS field-effect transistor or the n-channel MIS field-effect transistor.

7. The circuit according to claim 6, wherein
   gate widths of a top surface and a side surface of the p-channel MIS field-effect transistor and the n-channel MIS field-effect transistor are set such that the current drive capability of the p-channel MIS field-effect transistor can be substantially equal to current drive capability of the n-channel MIS field-effect transistor.

8. The circuit according to claim 6 or 7, wherein
   the switched capacitor circuit comprises a switch formed by connecting in parallel the p-channel MIS field-effect transistor with the n-channel MIS field-effect transistor.

F I G. 1

F I G. 2

F I G. 3

EP 1 635 393 A1

F I G.  4

EP 1 635 393 A1

F I G. 5

F I G. 6

F I G.  7

## INTERNATIONAL SEARCH REPORT

| International application No. |
| --- |
| PCT/JP2004/008220 |

**A. CLASSIFICATION OF SUBJECT MATTER**
    Int.Cl⁷ H01L27/092, H03H19/00, H01L29/78, H01L21/336.

According to International Patent Classification (IPC) or to both national classification and IPC

**B. FIELDS SEARCHED**

Minimum documentation searched (classification system followed by classification symbols)
    Int.Cl⁷ H01L27/092, H03H19/00, H01L29/78, H01L21/336

Documentation searched other than minimum documentation to the extent that such documents are included in the fields searched
    Jitsuyo Shinan Koho          1922-1996   Jitsuyo Shinan Toroku Koho   1996-2004
    Kokai Jitsuyo Shinan Koho    1971-2004   Toroku Jitsuyo Shinan Koho   1994-2004

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y<br>A | JP 2002-118255 A (Toshiba Corp.),<br>19 April, 2002 (19.04.02),<br>Full text; all drawings<br>& US 2002/011612 A1<br>Full text; all drawings | 1-3,5,7,8<br>4,6 |
| Y<br>A | JP 2002-261097 A (Tadahiro OMI),<br>13 September, 2002 (13.09.02),<br>Full text; all drawings<br>& EP 1347506 A1<br>Full text; all drawings<br>& WO 2002/054473 A1      & JP 2002-261091 A<br>& KR 3068570 A | 1-3,5,7,8<br>4,6 |

☒ Further documents are listed in the continuation of Box C.          ☐ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>  06 August, 2004 (06.08.04) | Date of mailing of the international search report<br>  24 August, 2004 (24.08.04) |
| --- | --- |
| Name and mailing address of the ISA/<br>    Japanese Patent Office | Authorized officer |
| Facsimile No. | Telephone No. |

Form PCT/ISA/210 (second sheet) (January 2004)

**INTERNATIONAL SEARCH REPORT**

International application No.

PCT/JP2004/008220

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 11-163647 A (Denso Corp.),<br>18 June, 1999 (18.06.99),<br>Full text; all drawings<br>(Family: none) | 1-3,5,7,8<br>4,6 |

Form PCT/ISA/210 (continuation of second sheet) (January 2004)